# EUROPÄISCHE PATENTANMELDUNG

(11) **EP 1 463 167 A2**
(43) Veröffentlichungstag der Anmeldung: **29.09.2004**
(21) Anmeldenummer: 04004743.3
(22) Anmeldetag: 01.03.2004
(51) Int. Cl.: H02B 1/30

(54) **Schrank**

(30) Priorität: 28.03.2003 DE 10314200
(71) Anmelder: Knürr AG, 94424 Arnstorf (DE)
(72) Erfinder: Bumeder, Gerhard, 84164 Moosthenning (DE); Prinz, Alexander, 84389 Postmünster (DE); Flamme, Hans, 82004 Unterhaching (DE); Knab, Josef, 94439 Rossbach (DE); Schneiderbauer, Siegfried, 94439 Rossbach (DE); Hupfloher, Helmut, 94424 Arnstorf (DE)
(74) Vertreter: Heim, Hans-Karl, Dipl.-Ing.

(57) **Zusammenfassung**

Die Erfindung betrifft einen Schrank zur Aufnahme elektrischer und elektronischer Geräte und Baugruppen, insbesondere Telekommunikationsschrank, mit Seitenwänden, einer Rückwand, einer Tür, einem Boden und einer Abdeckung, wobei zur Abschirmung des Schrankinneren gegenüber elektromagnetischen Wellen eine EMV-Abschirmung vorgesehen ist. Der Schrank ist dadurch gekennzeichnet, dass die Seitenwände mit dem Boden und der Abdeckung eine selbsttragende Einheit bilden.

## Beschreibung

Die vorliegende Erfindung betrifft einen Schrank zur Aufnahme elektrischer und elektronischer Geräte und Baugruppen, insbesondere einen Telekommunikationsschrank, nach dem Oberbegriff des Anspruchs 1.

Ein gattungsgemäßer Schrank ist in DE 202 04 910.8 U1 beschrieben und weist Seitenwände, eine Rückwand, eine Tür, einen Boden und eine Abdeckung auf, wobei zur Abschirmung des Schrankinneren gegenüber elektromagnetischen Wellen eine EMV-Abschirmung vorgesehen ist.

Solche Schränke werden in vielfältigen Varianten als Schalt- und Geräteschränke eingesetzt und sind häufig auch zum Aufbau von Schrank- und Gehäusesystemen geeignet, insbesondere in 19"-Technik.

Bekannte Schränke der oben angegebenen Art sind aus einem Rahmengestell aufgebaut, an dem Seitenteile, Rückwand, Tür sowie Boden und Deckelteil als Verkleidungsteile befestigt werden. Diese Fertigungsweise ermöglicht zwar stabile Aufbauten, die außerdem sehr flexibel gestaltet werden können. Wegen der Vielzahl der benötigten Teile und herzustellenden mechanischen und, um die notwendige elektromagnetische Verträglichkeit EMV zu erzielen auch elektrischen Verbindungen, sind der Konstruktionsaufwand und entsprechend die Fertigungskosten bei dieser Art von Geräteschränken sehr hoch.

**Aufgabe** der Erfindung ist es, einen Schrank der oben beschriebenen Art anzugeben, der besonders unaufwändig und Kosten sparend gefertigt werden kann.

Diese Aufgabe wird durch einen Schrank mit den Merkmalen des Anspruchs 1 gelöst.

Vorteilhafte Weiterbildungen des erfindungsgemäßen Schranks sind Gegenstand der Unteransprüche, der nachfolgenden Beschreibung sowie der Figuren.

Ein Schrank der oben angegebenen Art ist erfindungsgemäß dadurch weitergebildet, dass die Seitenwände mit dem Boden und der Abdeckung eine selbsttragende Einheit bilden.

Als ein Kerngedanke der Erfindung kann angesehen werden, den Schrank nicht mehr in einer Rahmenkonstruktion mit daran anzubringenden Verkleidungselementen aufzubauen, sondern bereits aus wenigen Teilen des Schranks, die gleichzeitig einen wesentlichen Teil der Umhüllungsfunktion wahrnehmen, nämlich aus Wänden, Boden- und Deckenteil, eine selbsttragende Einheit aufzubauen. Bei dem erfindungsgemäßen Schrank werden im Vergleich zum Stand der Technik deutlich weniger Teile benötigt, so dass auch die Zahl der herzustellenden mechanischen Verbindungen erheblich reduziert werden kann. Insbesondere kann bei dem erfindungsgemäßen Schrank auf eine aufwendige und teure Rahmenkonstruktion, beispielsweise eine Aluprofilkonstruktion, verzichtet werden. Gleichwohl werden, da die erforderliche Steifigkeit in die bisher als Verkleidungsteile bezeichneten Komponenten integriert wird, im Hinblick auf die mechanische Stabilität hervorragende Ergebnisse, jedoch mit deutlich reduzierten Mitteln, erreicht.

Weiterhin kann durch die verringerte Teilezahl auch die elektromagnetische Verträglichkeit EMV mit erheblich geringerem Aufwand bereitgestellt werden.

Wesentliche Vorteile der Erfindung sind daher der reduzierte Material- und Fertigungsaufwand und damit die geringeren Fertigungskosten.

Der erfindungsgemäße Schrank ist bevorzugt als Metallschrank ausgebildet, wobei zumindest Seitenwände, Boden, Abdeckung, Tür und Rückwand aus Metall gefertigt sind.

Bei einer besonders bevorzugten Weiterbildung des Schranks sind die Seitenwände mit dem Boden und der Abdeckung in Verbindungsbereichen durch Stauch-Press-Verbindungen zu dem selbsttragenden Aufbau, der auch als Grundgestell oder Korpus bezeichnet werden kann, verbunden. Bei dieser Art der Verbindung kommt es nicht zu Beschädigungen der Oberfläche, wie z.B. beim Schweißen, insbesondere beim Punktschweißen. Eine Variante dieser Verbindungstechnik ist beispielsweise das Durchsetzfügen, das auch als "Toxen" oder "Clinchen" bezeichnet wird. Bei diesen Fügetechniken wird eine formschlüssige Verbindung ohne Beschädigung der Oberfläche, beispielsweise der Zinkoberfläche der Bleche, realisiert. Auch eine Korrosion, das heißt Oxidieren oder Rosten, infolge einer Beschädigung der Oberflächen kann bei dieser Verbindungstechnik weitestgehend vermieden werden.

Zweckmäßig sind dabei die zu verbindenden Teile in den Verbindungsbereichen metallisch blank, d.h. nicht lackiert, so dass durch die Stauch-Press-Verbindung gleichzeitig auch ein sichererer elektrischer Kontakt zwischen den zu verbindenden Teilen bereitgestellt wird. Dies ist im Hinblick auf die elektromagnetische Verträglichkeit EMV bezweckt und erwünscht.

Zur EMV-Abschirmung können außerdem die Seitenwände und/oder der Boden und/oder die Abdeckung Kontaktnoppen aufweisen, die insbesondere in den Verbindungsbereichen angeordnet sein können. Solche Kontaktnoppen können in bekannter Weise mit herkömmlichen Prägewerkzeugen in die entsprechenden Teile eingearbeitet werden.

Insgesamt liegt der Erfindung ein ganzheitliches EMV-Konzept des selbsttragenden Aufbaus oder Korpus zugrunde, wobei die elektromagnetische Verträglichkeit dieses selbsttragenden Aufbaus prinzipiell ohne EMV-Federn, sondern allein durch Kontaktnoppen und durch die beim Durchsetzfügen, insbesondere beim Toxen oder Clinchen, erzeugten formschlüssigen Verbindungen bereitgestellt wird.

Eine verbesserte Vertikalstabilität und Höhenversteifung des Aufbaus wird erreicht, wenn die Seitenwände mit Vertikalschenkeln versehen werden. Diese können insbesondere L-förmig ausgebildet sein und jeweils einen front- bzw. rückseitigen Schenkel mit einem nach außen gerichteten Dichtungsschenkel aufweisen. Da diese Schenkel durch einfaches Abkanten des Blechs eingearbeitet werden können, lassen sich hochstabile Bauteile unaufwändig realisieren.

Eine noch höhere Stabilität in Vertikal- oder X-Achsenrichtung kann erzielt werden, wenn die Seitenwände, beispielsweise jeweils mittig zwischen den an den seitlichen Rändern der Seitenwände eingearbeiteten Vertikalschenkeln, zusätzlich mit vertikalen Versteifungsprofilen versehen sind. An diesen vertikalen Versteifungsprofilen, die durch Toxen, aber auch mit Hilfe von bekannten Verbindungstechniken, beispielsweise durch Nieten, mit den Seitenwänden verbunden sein können, können außerdem vertikale Holme fixiert werden, die zur Aufnahme von 19"-Komponenten ausgebildet sind.

Bei einer weiteren zweckmäßigen Ausgestaltung des erfindungsgemäßen Schranks weisen die Seitenwände obere und untere Schenkel sowie der Boden und die Abdeckung seitliche Abkantungen auf, die die Verbindungsbereiche der selbsttragenden Einheit bilden. Diese Verbindungsbereiche können wiederum durch einfaches Abkanten, d.h. fertigungstechnisch unaufwändig hergestellt werden. Die seitlichen Abkantungen dienen außerdem der Horizontal- oder Tiefenversteifung.

Ein Schutz des Verbindungsbereichs vor mechanischer Einwirkung wird erzielt, wenn die oberen und unteren Schenkel der Seitenwände L-förmig ausgebildet sind und über die seitlichen Abkantungen des Bodens bzw. der Abdeckung reichen. In diesem Zusammenhang kann außerdem eine weitere Verbesserung der Stabilität dadurch erzielt werden, dass die seitlichen Abkantungen des Bodens bzw. der Abdeckung formschlüssig in die L-förmig ausgebildeten oberen bzw. unteren Schenkel der Seitenwände eingreifen.

Eine weitere Maßnahme zur Stabilitätsverbesserung, die fertigungstechnisch wiederum durch einfaches Abkanten erzielt werden kann, besteht darin, dass der Boden und die Abdeckung seitliche Abkantungen aufweist, die nach oben bzw. nach unten überstehen und im Querschnitt ein beispielsweise rechtwinkliges Dreieck bilden. Zweckmäßig werden diese Abkantungen so ausgeführt, dass ein vertikaler Schenkel des Dreiecks an dem L-förmigen Schenkel der Wände anliegt und mit diesem den Verbindungsbereich bildet, in dem eine Mehrzahl von Verbindungen, beispielsweise Tox- und/oder Clinchverbindungen, vorgesehen sind.

Zum Anbringen dieser Stauch-Press-Verbindungen, insbesondere von Tox-Verbindungen können die seitlichen Abkantungen des Bodens und/oder der Abdeckung zweckmäßig mit einer Mehrzahl von Ausnehmungen versehen sein. Hierdurch wird das Anbringen der entsprechenden Verbindungen wesentlich erleichtert und ist mit herkömmlichen Werkzeugen durchführbar.

Zum Schutz des Schranks vor einer Einwirkung von oben kann eine Abdeckhaube vorgesehen sein, wobei zu deren Aufnahme in die oberen Schenkel der Seitenwände Ausnehmungen, insbesondere Schlitze oder Langlöcher, eingearbeitet sein können.

Eine noch größere Verwindungsstabilität des mechanischen Aufbaus wird bei einer Weiterbildung erzielt, bei der die Seitenwände an den front- und rückseitigen Schenkeln Schenkelbereiche aufweisen, die über bzw. unter den abgekanteten Dichtungsschenkeln auf front- und rückseitig ausgebildete vertikale Abbiegungen des Bodens und der Abdeckung übergreifen. Dadurch wird in einer Richtung quer zu den Verbindungsbereichen ein zweiter Kontaktbereich geschaffen, der wirkungsvoll die Stabilität erhöht.

Zur Bereitstellung der elektromagnetischen Verträglichkeit EMV ist die Abdeckung und/oder der Boden zweckmäßig wenigstens frontseitig mit einer EMV-Kabeleinführung, insbesondere aus leitfähigem Elastomer, versehen. Eine solche EMV-Kabeleinführung ermöglicht einerseits die Zuführung elektrischer Leitungen, wobei gleichzeitig Öffnungen des Gehäuses weitestgehend ausgefüllt werden, so dass elektromagnetische Strahlung weder aus- noch eindringen kann. Andererseits kann durch die EMV-Dichtung eine elektrische Kontaktierung zwischen verschiedenen Bauteilen des Schranks, insbesondere zwischen Bodenteil bzw. Abdeckung und Tür erzielt werden. In diesem Zusammenhang ist insbesondere zweckmäßig, dass die Tür im Bereich der EMV-Dichtung des Bodens und/oder der Abdeckung für einen elektrisch leitfähigen Kontakt einen unlackierten Bereich aufweist.

Um elektrische Leitungen mechanisch solide zu verlegen, kann die Abdeckung und/oder der Boden einen Winkel mit Ausnehmungen aufweisen, der horizontal absteht und mit einem zweiten Winkel und einer EMV-Dichtung für eine EMV-Kabeleinführung zusammenwirkt.

Zum Schutz des Schranks vor Korrosion sind bevorzugt wenigstens die sichtbaren Außenflächen der Seitenwände sowie des Bodens und der Abdeckung lackiert. Bezüglich der Abdichtung des Verbindungsbereichs zwischen Tür bzw. der Rückwand und den Seitenwänden gegenüber elektromagnetischer Strahlung sind bevorzugt EMV-Federn für einen elektrischen Kontakt zwischen der Tür bzw. der Rückwand und den Seitenwänden vorgesehen.

Zur stabilen Positionierung bzw. für Transportzwecke können der Boden mit verstellbaren Füßen und die Abdeckung mit Transportbefestigungseinrichtungen, beispielsweise Haken, versehen portbefestigungseinrichtungen, beispielsweise Haken, versehen sein. Hierzu können zweckmäßig in Boden und/oder Abdeckung entsprechende Gewindehülsen vorgesehen sein.

Die Rückwand kann mit bekannten Verbindungstechniken, beispielsweise durch Verschrauben mit den übrigen Teilen des Schranks, insbesondere den Seitenwänden, verbunden sein. Sämtliche Bauteile können zu Belüftungszwecken mit Perforierungen versehen sein, wobei im Hinblick auf die elektromagnetische Verträglichkeit in bekannter Weise die Lochgröße zu beachten ist.

Um zuverlässig zu gewährleisten, dass der Schrank auch bei eventuellen Erschütterungen, beispielsweise auch im Extremfall eines Erdbebens, verschlossen ist, können die Tür und die Seitenwände mit Verschlusselementen versehen sein. Hierbei kann es sich insbesondere um betätigbare Verschlusselemente, beispielsweise Verschlussgestänge mit dazugehörigen Betätigungseinrichtungen, wie Klinken, Griffen und/oder Hebeln handeln. In üblicher Weise können auch abschließbare Schlösser vorgesehen sein. Als Verschlusselemente können am Gehäusekorpus und/oder an der Tür auch Haken, beispielsweise Doppelhaken, vorgesehen sein. An dem jeweils gegenüberliegenden Teil wird dann zweckmäßig ein entsprechendes Gegenstück vorgesehen, das mit den Haken in Eingriff bringbar ist.

Eine Stabilisierung gegenüber Verschiebungen der Tür gegenüber dem Korpus, insbesondere in Vertikalrichtung, kann dadurch erzielt werden, dass in der Tür und/oder im Korpus, beispielsweise im Bereich einer randseitigen vertikalen Abkantung Ausnehmungen, die auch als Ausklinkungen bezeichnet werden können, vorgesehen sind, in denen die Verschlusselemente, die an den Seitenwänden aber eventuell auch an Decken- und/oder Bodenteil angeordnet sind, zumindest teilweise formschlüssig aufnehmbar sind. Insbesondere können diese Ausnehmungen Kanten aufweisen, an denen sich die entsprechenden Verschlusselemente bei vertikaler und/oder horizontaler Verschiebung abstützen können.

Der große Vorteil einer formschlüssigen Abstützung der Fronttüre gegen die Verschlusselemente besteht darin, dass sich die Türe z.B. während eines Erdbebentests an den Verschlusselementen abstützt und somit erheblich zur Versteifung des Schrankes beiträgt. Die vertikale Abkantung auf der Verschlussseite der Türe, die auch als Kastenbug bezeichnet wird, weist hierzu eine entsprechende Ausnehmung oder Ausklinkung auf. Hierdurch können sonst übliche aufwändige und teure Versteifungselemente, wie z.B. zusätzliche Knotenbleche zur Abstützung entfallen.

Weitere Vorteile und Eigenschaften der Erfindung werden nachstehend unter Bezugnahme auf die Figuren beschrieben.

Darin zeigt:
- Fig. 1: eine perspektivische Ansicht eines Ausführungsbeispiels des erfindungsgemäßen Schranks ohne Tür und Rückwand;
- Fig. 2: eine Vorderansicht des Schranks aus Fig. 1;
- Fig. 3: eine Seitenansicht des Schranks aus Fig. 1;
- Fig. 4: eine Horizontalschnittansicht des erfindungsgemäßen Schranks;
- Fig. 5: ein Detail der in Fig. 2 gezeigten Seitenansicht; und
- Fig. 6: eine perspektivische Teilansicht einer Türinnenseite.

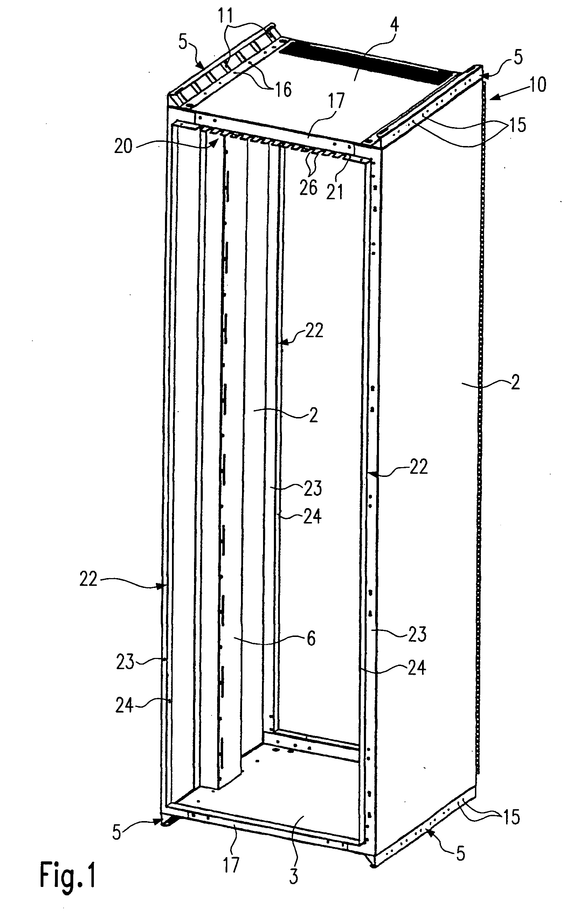

Figur 1 zeigt ein Ausführungsbeispiel des erfindungsgemäßen Schranks. Zur besseren Übersichtlichkeit wurden Tür und Rückwand weggelassen. Erfindungsgemäß bilden zwei Seitenwände 2 zusammen mit einem Boden 3 und einer Abdeckung 4 eine selbst- bzw. der Abdeckung 4 in Verbindungsbereichen 5 mit Hilfe jeweils einer Mehrzahl von Tox-Verbindungen als Stauch-Press-Verbindungen 15 befestigt. Neben einer mechanischen Verbindung wird durch diese Tox-Verbindungen 15 auch ein elektrisch leitender Kontakt bereitgestellt, was im Hinblick auf die elektromagnetische Abschirmung erwünscht und bezweckt ist. In diesem Zusammenhang sind außerdem in den Verbindungsbereichen 5 der Seitenwände 2, des Bodens 3 und der Abdeckung 4 eine Mehrzahl von Kontaktnoppen 16 vorgesehen. Bei diesen Kontaktnoppen 16 kann es sich beispielsweise um kreisscheibenartige Einprägungen handeln, wobei das Blech in diesem Bereich zur Ermöglichung eines elektrischen Kontakts zweckmäßig metallisch blank belassen wird.

Eine elektrische Kontaktierung zwischen Seitenteilen 2 und Boden 3 bzw. Abdeckung 4 erfolgt demnach im gezeigten Ausführungsbeispiel sowohl über die Tox-Verbindungen 15 als auch über die Kontaktnoppen 16.

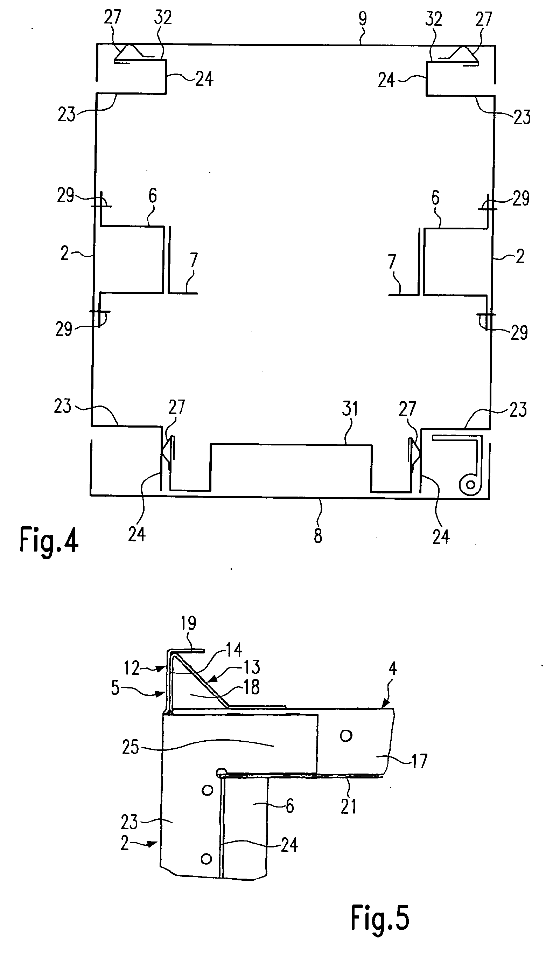

Zur Erzielung einer verbesserten Verwindungssteifigkeit sind die Seitenteile 2 an beiden vertikal verlaufenden Rändern jeweils mit L-förmig ausgebildeten Vertikalschenkeln 22 versehen, die einen front- bzw. rückseitigen Schenkel 23 mit einem nach außen gerichteten Dichtungsschenkel 24 aufweisen. Die Dichtungsschenkel 24 übernehmen eine Funktion bei der elektromagnetischen Abschirmung des Schranks, wie nachstehend im Zusammenhang mit Fig. 4 beschrieben wird.

weiterhin sind zur Stabilisierung der Seitenwände 2 jeweils im Schrankinneren verlaufende vertikale Versteifungsprofile 6 befestigt. Diese Versteifungsprofile 6 verlaufen etwa mittig zwischen den beiden vertikalen Rändern der Seitenwände 2 und erstrecken sich über die gesamte Höhe der Seitenwände 2.

Um auch bei dem Boden 3 und der Abdeckung 4 eine höhere Versteifung zu erzielen, sind diese Bauteile, den Vertikalschenkeln 22 der Seitenwände 2 entsprechend, mit vertikalen Abbiegungen 17 versehen. An der Frontseite der Abdeckung 4 schließt sich an die dort ausgebildete vertikale Abbiegung 17 ein sich horizontal erstreckender Winkelbereich 21 an, in den Ausnehmungen oder Ausbuchtungen 26 zur Aufnahme elektrischer Zuleitungen eingearbeitet, beispielsweise eingestanzt sind. Zweckmäßig ist an diesem Winkel 21 eine EMV-Kabeleinführung, insbesondere aus einem leitfähigen Elastomer, angeordnet. Beispielsweise kann die EMV-Kabeleinführung angeklebt oder auch mit Hilfe eines weiteren Bauteils, beispielsweise eines Blechstreifens an dem Winkel 21 fixiert sein. Die EMV-Kabeleinführung kann beispielsweise von der in DE 202 04 910.8 U1 beschriebenen Art sein. Im Unterschied zu dem in diesem Gebrauchsmuster beschriebenen Aufbau besteht die bei der vorliegenden Erfindung einzusetzende EMV-Kabeleinführung nicht mehr aus drei Einzelteilen, sondern nur noch aus einem Stahlblechwinkel und einer EMV-Dichtung. Der zweite Stahlblechwinkel ist bei der vorliegenden Erfindung in die Deckelkonstruktion integriert. Prinzipiell kann bei dem erfindungsgemäßen Schrank zusätzlich oder alternativ auch eine EMV-Kabeleinführung der in Fig. 12 von DE 202 04 910.8 U1 gezeigten Art vorgesehen sein.

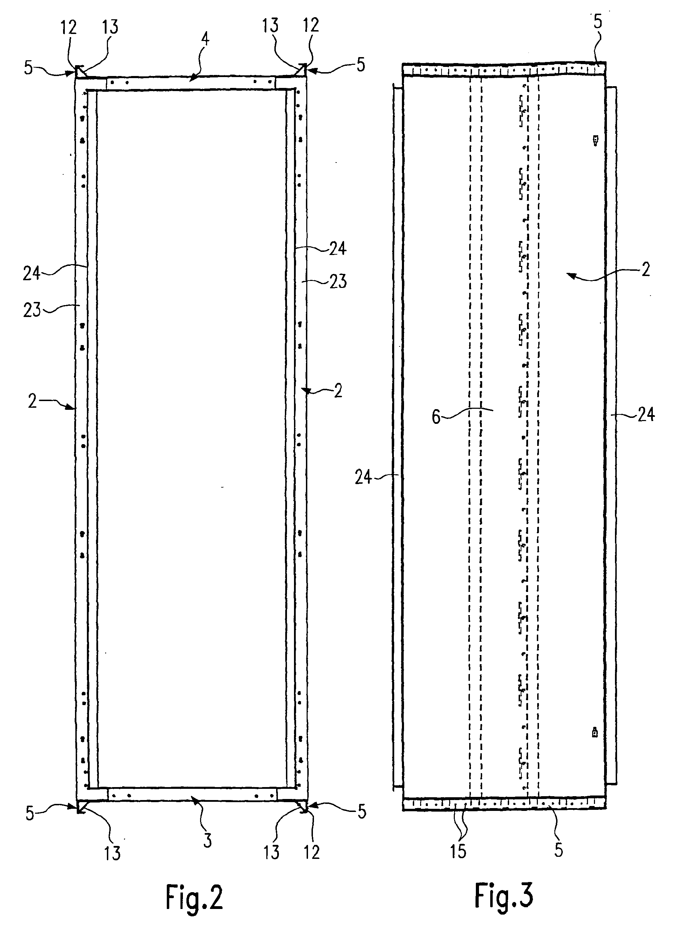

Die Fig. 2 und 3 zeigen eine Frontansicht bzw. eine Seitenansicht der in Fig. 1 dargestellten selbsttragenden Einheit 10, wobei einander entsprechende Komponenten jeweils mit denselben Bezugszeichen versehen sind. Die Fig. 2 und 3 verdeutlichen den räumlichen Verlauf der front- und rückseitigen Schenkel 23 quer zur Fläche der Seitenwände 2 sowie der sich daran anschließenden Dichtungsschenkel 24 in Richtung der Seitenwände 2. Weiterhin ist in Fig. 3 der Verlauf des vertikalen Versteifungsprofils 6 verdeutlicht.

Zur Bereitstellung der Verbindungsbereiche 5 sind die Seitenwände 2 mit L-förmigen oberen und unteren Schenkeln 12 sowie Boden 3 und Abdeckung 4 mit seitlichen Abkantungen 13 versehen.

Details dieses Bereichs zeigt Fig. 5. Die seitliche Abkantung 13 der Abdeckung 4 weist die Form eines Dreiecks 18 auf, wobei Details dieses Bereichs zeigt Fig. 5. Die seitliche Abkantung 13 der Abdeckung 4 weist die Form eines Dreiecks 18 auf, wobei ein vertikal verlaufender Schenkel 14 an dem oberen Schenkel 12 der Seitenwand 2 anliegt und mit diesem den Verbindungsbereich 5 bildet. Der L-förmig ausgebildete obere Schenkel 12 der Seitenwand 2 weist außerdem einen oberen Teilschenkel 19 auf, der sich teilweise über die seitliche Abkantung 13 der Abdeckung 4 erstreckt. In diesen oberen Teilschenkel 19 können Ausnehmungen, insbesondere Schlitze oder Langlöcher eingearbeitet, beispielsweise eingestanzt sein, die zur Aufnahme und Fixierung einer Abdeckhaube dienen können.

Der frontseitige Schenkel 23 der Seitenwand 2 weist außerdem einen Schenkelbereich 25 auf, der die vertikale Abbiegung 17 der Abdeckung 4 überdeckt und an dieser im Wesentlichen anliegt. Auf diese Weise wird eine weitere Erhöhung der Verwindungssteifigkeit erzielt. Fig. 5 verdeutlicht außerdem den Verlauf des Winkels 21 und des Dichtungsschenkels 24 quer zur vertikalen Abbiegung 17 bzw. zum frontseitigen Schenkel 23.

Die räumliche Anordnung der verschiedenen Abkantungen und Schenkel ist außerdem aus Fig. 4, die einen Horizontalschnitt durch den selbsttragenden Aufbau 10 zeigt, ersichtlich, wobei wiederum für entsprechende Komponenten dieselben Bezugszeichen wie in den übrigen Figuren verwendet wurden.

Wie in Fig. 4 gezeigt, sind an den vertikalen Versteifungsprofilen 6, die beispielsweise an den Seitenwänden 2 mit Nieten 29 befestigt sein können, außerdem vertikale Holme 7 angeordnet, die insbesondere zur Aufnahme von 19□-Komponenten in dem Schrank dienen können. Die vertikalen Holme 7 sind dabei als einfaches Winkelprofil und die vertikalen Versteifungsprofile 6 als U-Profil mit Anlageschenkeln ausgebildet, wodurch hervorragende Festigkeitseigenschaften des Aufbaus erreicht werden.

Fig. 4 zeigt den erfindungsgemäßen Schrank in geschlossenem Zustand, d.h. mit angeschraubter Rückwand 9 und geschlossener Tür 8. Zur Bereitstellung einer elektromagnetischen Abschirmung in diesem geschlossenen Zustand ist die Tür 8 mit einem Innenprofil 31 versehen, das an der Frontplatte in bekannter Weise befestigt, beispielsweise vernietet, sein kann. An diesem Innenprofil 31, das im gezeigten Ausführungsbeispiel als Doppel-U-Profil oder Hutprofil ausgebildet ist, sind an den außenliegenden Schenkeln EMV-Federn 27 angebracht, die beim Schließen der Tür 8 mit den Dichtungsschenkeln 24 der Vertikalschenkel 22 der Seitenwände 2 in elektrischen Kontakt kommen und so diese Verbindungsstelle elektromagnetisch abdichten. Durch die Tür 8 und die verschraubte Rückwand 9 wird außerdem die Verwindungssteifigkeit des Gesamtaufbaus noch weiter erhöht.

Im Bereich der Rückwand 9 ist die elektromagnetische Abschirmung geringfügig unterschiedlich ausgeführt. Die Dichtungsschenkel 24 erstrecken sich weiter in Schenkel 32, die etwa parallel zur Rückwand 9 verlaufen und an denen jeweils EMV-Federn angeordnet sind. Beim Befestigen der Rückwand 9 an dem selbsttragenden Aufbau 10 kommen diese EMV-Federn 27 mit der Rückwand 9 in elektrischen Kontakt, die an den entsprechenden Stellen zweckmäßig metallisch blank belassen wird.

Die elektromagnetische Abschirmung zwischen Rückwand 9 und Schrankkorpus bzw. zwischen Tür 8 und Schrankkorpus wurde hier zu Zwecken der Illustration anhand des Beispiels einer EMV-Feder beschrieben. An den entsprechenden Stellen kann aber auch jede andere Art von EMV-Dichtungen eingesetzt werden, wie z.B. eine leitende Silikonschnur, ein leitendes Elastomer und/oder eine Textildichtung.

Bei der Fertigung des in den Figuren dargestellten Ausführungsbeispiels eines erfindungsgemäßen Schranks kann völlig auf Schweißverbindungen verzichtet werden, wodurch in erheblichem Umfang Kosten gespart werden können. Außerdem ergeben sich, da insgesamt nur sieben Hauptgruppen eingesetzt werden, Vorteile im Hinblick auf die Fertigungszeit.

Bei dem in den Figuren gezeigten Ausführungsbeispiel werden weiterhin, um Kosten für das Lackieren und das aufwändige Abdecken zu sparen, nur die sichtbaren äußeren Teile lackiert. Die Abdeckung 4, der Boden 3 und die 19□-Vertikalprofile 7 werden blank belassen. Beispielsweise können diese Bauteile aus einem 1,5 mm dicken feuerverzinkten Stahlblech ausgeführt werden. Weitere Kosteneinsparungen sind möglich, wenn Seitenwände 2, Rückwand 9 und Tür 8 nur einseitig pulverbeschichtet werden.

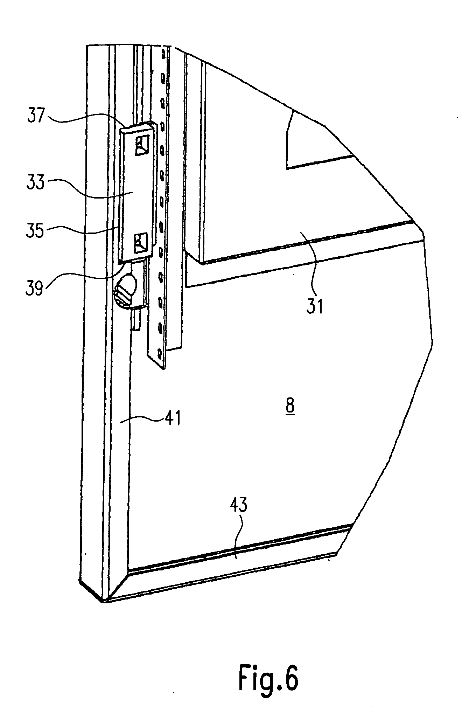

Fig. 6 zeigt in einer perspektivischen Teilansicht den unteren äußeren Bereich der Innenseite einer Tür 8. Die Tür 8 besteht im Wesentlichen aus einem Blech mit an den Randbereichen angebrachten vertikalen und horizontalen Abkantungen 41, 43. Teilweise zu sehen ist auch das in der Schnittzeichnung in Fig. 4 dargestellte Innenprofil 31.

In die vertikale Abkantung 41 ist eine Ausnehmung 35 eingearbeitet, in welche ein Verschlusselement 33 teilweise formschlüssig aufnehmbar ist. Um dies zu verdeutlichen, ist in Fig. 6 auch das entsprechende Verschlusselement 33, das im Benutzungszustand des Schranks am Korpus, d.h. an einem der Seitenteile 2 befestigt ist, dargestellt. Die Ausnehmung 35 weist einen oberen Rand 37 und einen unteren Rand 39 auf, an dem sich das am Korpus befestigte Verschlusselement 33, bei dem es sich im Wesentlichen um eine rechteckige Metall- oder Kunststoffplatte handelt, im Fall vertikaler Verschiebungen abstützen kann.

Durch die vorliegende Erfindung wird ein neuartiger Schrank zur Aufnahme elektrischer und elektronischer Geräte und Baugruppen bereitgestellt, der wegen der deutlich reduzierten Anzahl von Bauteilen und dem dadurch erheblich geringeren Fertigungsaufwand wesentlich kostengünstiger hergestellt werden kann, wobei gleichwohl hervorragende Stabilitätseigenschaften erzielt werden.

## Patentansprüche

1. Schrank zur Aufnahme elektrischer und elektronischer Geräte und Baugruppen, insbesondere Telekommunikationsschrank,
mit Seitenwänden (2), einer Rückwand (9), einer Tür (8), einem Boden (3) und einer Abdeckung (4), wobei zur Abschirmung des Schrankinneren gegenüber elektromagnetischen Wellen eine EMV-Abschirmung vorgesehen ist,
**dadurch gekennzeichnet,**
**dass** die Seitenwände (2) mit dem Boden (3) und der Abdeckung (4) eine selbsttragende Einheit (10) bilden.

2. Schrank nach Anspruch 1,
**dadurch gekennzeichnet,**
**dass** die Seitenwände (2) mit dem Boden (3) und der Abdeckung (4) in Verbindungsbereichen (5) durch Stauch-Press-Verbindungen (15) verbunden sind.

3. Schrank nach Anspruch 1 oder 2,
**dadurch gekennzeichnet,**
**dass** die Seitenwände (2) und/oder der Boden (3) und/oder die Abdeckung (4), insbesondere in den Verbindungsbereichen (5), Kontaktnoppen (16) zur EMV-Abschirmung aufweisen.

4. Schrank nach einem der vorhergehenden Ansprüche,
**dadurch gekennzeichnet,**
**dass** die Seitenwände (2) Vertikalschenkel (22) aufweisen, welche L-förmig ausgebildet sind und jeweils einen front- bzw. rückseitigen Schenkel (23) mit einem nach außen gerichteten Dichtungsschenkel (24) aufweisen.

5. Schrank nach einem der vorhergehenden Ansprüche,
**dadurch gekennzeichnet,**
**dass** Seitenwände (2), Boden (3), Abdeckung (4), Tür (8) und Rückwand (9) aus Metall gefertigt sind.

6. Schrank nach einem der vorhergehenden Ansprüche,
**dadurch gekennzeichnet,**
**dass** die Seitenwände (2) obere und untere Schenkel (12) und der Boden (3) und die Abdeckung (4) seitliche Abkantungen (13) aufweisen, welche die Verbindungsbereiche (5) der selbsttragenden Einheit (10) bilden.

7. Schrank nach einem der vorhergehenden Ansprüche,
**dadurch gekennzeichnet,**
**dass** die Seitenwände (2) obere und untere Schenkel (12) aufweisen, welche L-förmig ausgebildet sind und über die seitlichen Abkantungen (13) des Bodens (3) bzw. der Abdeckung (4) reichen.

8. Schrank nach einem der vorhergehenden Ansprüche,
**dadurch gekennzeichnet,**
**dass** der Boden (3) und die Abdeckung (4) seitliche Abkantungen (13) aufweisen, welche nach oben bzw. unten überstehen und im Querschnitt ein, insbesondere rechtwinkliges Dreieck bilden, wobei ein vertikaler Schenkel (14) des Dreiecks an dem L-förmigen Schenkel (12) der Wände (2) anliegt und mit diesem durch toxen oder clinchen verbunden ist.

9. Schrank nach einem der vorhergehenden Ansprüche,
**dadurch gekennzeichnet,**
**dass** die Seitenwände (2) an den front- und rückseitigen Schenkeln (23) Schenkelbereiche (25) aufweisen, welche über bzw. unter den abgekanteten Dichtungsschenkeln (24) auf front- und rückseitig ausgebildete, vertikale Abbiegungen (17) des Bodens (3) und der Abdeckung (4) übergreifen.

10. Schrank nach einem der vorhergehenden Ansprüche,
**dadurch gekennzeichnet,**
**dass** die Abdeckung (4) und/oder der Boden (3) wenigstens frontseitig mit einer EMV-Kabeleinführung (20), insbesondere aus leitfähigem Elastomer, versehen ist.

11. Schrank nach einem der vorhergehenden Ansprüche,
**dadurch gekennzeichnet,**
**dass** die Abdeckung (4) und/oder der Boden (3) einen Winkel (21) mit Ausnehmungen (26) aufweist, welcher horizontal absteht und mit einem zweiten Winkel und einer EMV-Dichtung für eine EMV-Kabeleinführung (20) zusammenwirkt.

12. Schrank nach einem der vorhergehenden Ansprüche,
**dadurch gekennzeichnet,**
**dass** die Tür (8) im Bereich einer EMV-Dichtung des Bodens (3) und/oder der Abdeckung (4) für einen elektrisch leitfähigen Kontakt einen unlackierten Bereich aufweist.

13. Schrank nach einem der vorhergehenden Ansprüche,
**dadurch gekennzeichnet,**
**dass** wenigstens die sichtbaren Außenflächen der Seitenwände (2) sowie des Bodens (3) und der Abdeckung (4) lackiert sind und
**dass** EMV-Federn (27) für einen elektrischen Kontakt zwischen der Tür (8) bzw. der Rückwand (9) und den Seitenwänden (2) vorgesehen sind.

14. Schrank nach einem der vorhergehenden Ansprüche,
**dadurch gekennzeichnet,**
**dass** die Rückwand (9) durch Verschraubungen mit den Seitenwänden (2) verbunden ist.

15. Schrank nach einem der vorhergehenden Ansprüche,
**dadurch gekennzeichnet,**
**dass** die seitlichen Abkantungen (13) des Bodens (3) und/oder der Abdeckung (4) zum Anbringen von Stauch-Press-Verbindungen, insbesondere von Tox-Verbindungen, mit den Seitenwänden (2) eine Mehrzahl von Ausnehmungen (11) aufweist.

16. Schrank nach einem der vorhergehenden Ansprüche,
**dadurch gekennzeichnet,**
**dass** die oberen Schenkel (12) der Seitenwände (2) Ausnehmungen, insbesondere Schlitze, zur Aufnahme einer Abdeckhaube aufweisen.

17. Schrank nach einem der vorhergehenden Ansprüche,
**dadurch gekennzeichnet,**
**dass** die Seitenwände (2) mit vertikalen Versteifungsprofilen (6) versehen sind und
**dass** vertikale Holme (7), welche zur Aufnahme von 19"-Komponenten ausgebildet sind, an den Versteifungsprofilen (6) fixierbar sind.

18. Schrank nach einem der vorhergehenden Ansprüche,
**dadurch gekennzeichnet,**
**dass** die Tür (8) und die Seitenwände (2) mit Verschlusselementen (33) versehen sind.

19. Schrank nach Anspruch 18,
**dadurch gekennzeichnet,**
**dass** zur Stabilisierung gegenüber Verschiebungen in Vertikalrichtung in der Tür (8) mindestens eine Ausnehmung (35), insbesondere im Bereich einer randseitigen vertikalen Abkantung (41) der Tür (8), vorgesehen ist, in der ein an den Seitenwänden (2) angeordnetes Verschlusselement wenigstens teilweise formschlüssig aufnehmbar ist.
